# EUROPÄISCHE PATENTANMELDUNG

(11) **EP 4 358 655 A1**
(43) Veröffentlichungstag der Anmeldung: **24.04.2024**
(21) Anmeldenummer: 23202584.1
(22) Anmeldetag: 10.10.2023
(51) Int. Cl.: H05K 1/11, H05K 1/18, F21S 4/20, F21V 23/06, F21V 33/00, H05K 1/02, H05K 3/28, F21Y 103/10, F21Y 115/10

(54) **LEITERPLATINE**

(30) Priorität: 21.10.2022 DE 202022105955 U
(71) Anmelder: Wilhelm Koch GmbH, 48231 Warendorf (DE)
(72) Erfinder: KERSTING, Oliver, 49201 Dissen (DE); EDENFELD, Johannes Ferdinand, 33397 Rietberg (DE); KÖHLER, Daniel, 32584 Löhne (DE)
(74) Vertreter: Specht, Peter

(57) **Zusammenfassung**

Leiterplatine mit an Niedervolt-Betriebsstrom angeschlossenen Leiterbahnen, die an einer Trägerbahn angeschlossen sind und mit denen elektrische Funktionselemente verbunden sind, wobei mindestens zwei Ebenen vorgesehen sind, von denen auf einer Ebene zwei, einen Funktionsstromleiter bildende Funktionsleiterbahnen angeordnet sind, an denen Funktionselemente, insbesondere LEDs, angeschlossen sind, und auf der anderen Ebene zumindest eine, einen Steuerstromleiter bildende Steuerleiterbahnen angeordnet ist, mit Kontaktstellen, die über Funktionselemente mit Anschlusskontakten des Funktionsstromleiters verbindbar sind.

## Beschreibung

Die Erfindung betrifft eine Leiterplatine nach dem Oberbegriff des Anspruchs 1.

Eine derartige Leiterplatine ist Bestandteil einer Lichtstreifenleuchte, wie sie in Möbeln Verwendung findet, beispielsweise als dekoratives Lichtelement und/oder als Funktionslicht, um einen Innenraum des Möbels zu beleuchten.

Dabei ist die Leiterplatine in einem Gehäuse positioniert, das in eine entsprechende Ausnehmung des Möbels eingefügt ist.

Diese Leuchten werden üblicherweise mit LED-Lichtquellen betrieben und im einfachsten Fall mit einem vorgeschalteten Schalter ein- und ausgeschaltet.

Weiter können elektronische Schaltelemente wie Infrarot-Sensoren, kapazitive Berührungsschalter, Abstands-Schaltsensoren oder dergleichen an die Leuchte angeschlossen sein, allerdings extern vor der Leuchte angeordnet.

Aus dem Stand der Technik sind weiter Sensoren bekannt, die in der Leuchte integriert und zwar als separate Einbaueinheit oder in einer Endkappe der Leuchte. Bekannt ist ebenso die Integration eines elektronischen Schaltkreises auf der LED-Platine im Bereich von Kontakten für einen Netzanschluss.

Zum Stand der Technik wird auf die DE 20 2013 104 307 U1 sowie auf die DE 20 2019 101 128 U1 verwiesen, in denen jeweils eine solche Leuchte bzw. eine Leiterplatine thematisiert ist.

Eine Leiterplatine gemäß der Gattung ist aus der DE 10 2013 203 666 A1 bekannt. Diese Leiterplatine weist zwei Strom führende Funktionsleiterbahnen auf einer Ebene auf, an denen über ein Widerstandselement und ein elektrisches Leitungselement LEDs angeschlossen sind. Eine vergleichbare Leiterplatine ist des Weiteren in der US 6 866 394 B1 thematisiert. Eine Funktionsbeeinflussung der LEDs ist damit allerdings nicht möglich.

Vor allem aus wirtschaftlichen Erwägungen werden von der Möbelindustrie Linearleuchten-Systeme gewünscht, die flexibel mit unterschiedlichen Sensor- und Steuerungssystemen bestückt werden können.

Dabei ist die Anordnung von Sensorsystemen, insbesondere die Sensorposition entlang der Leuchten-Linearachse als besonders wünschenswert angesehen, da eine bequeme Zugänglichkeit zu den Sensoren für den Benutzer ein besonderer Aspekt des Bedienungskomforts darstellt.

Eine weitere Forderung geht dahin, eine solche Leuchte auf eine wirtschaftlich akzeptable Art und Weise bereitzustellen, mit möglichst vielen identischen Komponenten und unterschiedlichen Sensorfunktionen, wobei mit geringem Aufwand eine Bestückung von Möbeln mit unterschiedlichen Abmessungen möglich sein soll.

Die bisher bekannten Linearleuchten sind allerdings nicht geeignet, diesen gestellten Forderungen zu entsprechen.

Der Erfindung liegt daher die Aufgabe zugrunde, eine Leiterplatine als Bestandteil einer Linearleuchte gemäß der Gattung so weiterzuentwickeln, dass ihre Verwendbarkeit verbessert wird.

Diese Aufgabe wird durch eine Leiterplatine mit den Merkmalen des Anspruchs 1 gelöst.

Durch die Erfindung ist eine Leiterplatine geschaffen, die prinzipiell endlos herstellbar ist, was zu einer besonders günstigen Lagerhaltung und Fertigung führt. Hierzu kann die Leiterplatine linear in Abständen erkennbare Trennstellen aufweisen, denen Anschlusskontakte zugeordnet sind, die mit den Leiterbahnen der Funktions-Stromleitung verbunden sind, ebenso wie zu Kontaktstellen des Steuerstromleiters.

Die Erfindung zeichnet sich insbesondere auch dadurch aus, dass verschiedene Betriebskonfiguration, je nach Kundenwunsch, herstellbar sind, im Wesentlichen mit den gleichen Komponenten.

Beispielsweise kann eine Ausführungsvariante darin bestehen, ausschließlich den Funktionsstromleiter an Netzstrom anzuschließen, so dass ausschließlich die am Funktionsstromleiter angeschlossenen LEDs betrieben werden können. In diesem Fall bleibt der Steuerstromleiter funktionslos.

Soll allerdings ein den Betrieb der LEDs beeinflussendes Funktionselement wie ein Sensor in Kombination mit einem Schalter Verwendung finden, so ist dieses Funktionselement an die eine notwendige Leiterbahn des Steuerstromleiters anzuschließen, während der Netzanschluss sowohl über diese eine Leiterbahn wie auch über den Funktionsstromleiter erfolgt, wobei beide Anschlüsse unterschiedlich gepolt sind.

Wie erwähnt, sind im Bereich der Trennstelle Anschlusskontakte vorgesehen, die an den Leiterbahnen des Funktionsstromleiters angeschlossen sind und zwar je nach Bestückung mit Funktionselementen an einer Leiterbahn oder an beiden, wobei zumindest die einer Leiterbahn zugeordneten Anschlusskontakte mit Kontaktstellen elektrisch in Verbindung stehen, die an der Leiterbahn des Steuerstromleiters angeschlossen sind.

Kommen weitere elektrische Funktionselemente, wie Sensoren oder dergleichen zum Einsatz, so werden diese mit dem Funktionsstromleiter sowie dem Steuerstromleiter elektrisch verbunden, der an das Netz angeschlossen ist.

Entsprechend der gewünschten Länge der zum Einsatz an einem bestimmten Möbel kommenden Leiterplatine, ist diese in den von den Trennstellen definierten Abständen trennbar, d.h., in beliebigen Längenabschnitten einkürzbar und zwar bevorzugt an der Stelle der Anschlusskontakte der Leiterbahnen des Funktionsstromleiters.

Neben der genannten unmittelbaren Stromversorgung des Funktionsstromleiters, wenn kein Sensor zum Einsatz kommt, kann dessen Stromversorgung auch über eine Kontaktierung des Steuerstromleiters erfolgen, der über Anschlusskontakte am Netzstrom angeschlossen ist.

Im Bedarfsfall können mehrere Steuerstromleiter in unterschiedlichen, parallelen Ebenen vorgesehen sein, die jeweils elektrisch mit dem Funktionsstromleiter verbindbar sind, so dass sich die Steuerstromleiter kreuzen können, um beispielsweise LEDs unterschiedlich zu beeinflussen.

Der Sensor und dessen elektronischer Schaltkreis kann als separate Komponente unabhängig von der Leiterplatine angeordnet sein und mit Leitungsverbindungen an jeder Trennstelle des Steuerstromleiters elektrisch angeschlossen sein.

Alternativ kann der Sensor auch direkt auf dem Steuerstromleiter befestigt und damit elektrisch verbunden sein, ebenso z. B. als sogenannte SMD-Einheit an vorbestimmten Stellen des Steuerstromleiters, wobei dies bereits bei der Herstellung der Leiterplatine erfolgen kann.

Die Anordnung eines beschriebenen Sensors ist beispielhaft zu sehen und kann als Berührungssensor Verwendung finden. Ergänzend oder alternativ ist auch der Einsatz eines IR-Sensors denkbar, ebenso eines Gestensensors oder Abstandssensors, dieser beispielsweise in TOF-Technik, Radartechnik oder dergleichen. Denkbar ist auch, andere Schaltelemente wie einen Blue-Tooth-Empfänger, Funkempfänger oder kombinierte Sender-Empfangssteuerungen einzusetzen.

Sowohl der Steuerstromleiter wie auch der Funktionsstromleiter mit angeschlossenen LEDs sind auf Ebenen der Trägerbahn gehalten und zwar gegenüberliegend auf einer Unter- und einer Oberseite oder nebeneinander liegend. Die Trennstellen können durch Markierungen oder Prägungen kenntlich gemacht sein, so dass die Leiterplatine mittels eines Schneidwerkzeugs durchtrennt werden kann.

Wie sich gezeigt hat, ist die Herstellung der neuen Leiterplatine mit geringem fertigungstechnischem Aufwand möglich und objektbezogen modifizierbar.

Weitere vorteilhafte Ausbildungen der Erfindung sind in den Unteransprüchen gekennzeichnet.

Ausführungsbeispiele der Erfindung werden nachfolgend anhand der beigefügten Zeichnungen beschrieben.

Es zeigen:
- Figur 1: in schematischer Ansicht eine Leiterplatine nach der Erfindung
- Figur 2: die Leiterplatine nach Figur 1 in einer weiteren Ausführungsform
- Figur 3: eine weiteres Ausführungsbeispiel der Erfindung, gleichfalls in einer schematischen Draufsicht
- Figur 4: die Leiterplatine nach Figur 3 in einer weiteren Ausführungsvariante
- Figur 5: einen vergrößerten Teilausschnitt der Leiterplatine nach Figur 3 in einer aufgebrochenen Draufsicht.

In den Figuren ist jeweils eine Leiterplatine abgebildet, mit auf einer Trägerbahn 1 befestigten Leiterbahnen, an denen elektrische Funktionselemente angeschlossen sind. Die Leiterplatine ist in einem nicht dargestellten Gehäuse einer Linearleuchte positioniert, wie sie aus der zum Stand der Technik genannten DE 20 2019 101 128 U1 bekannt ist.

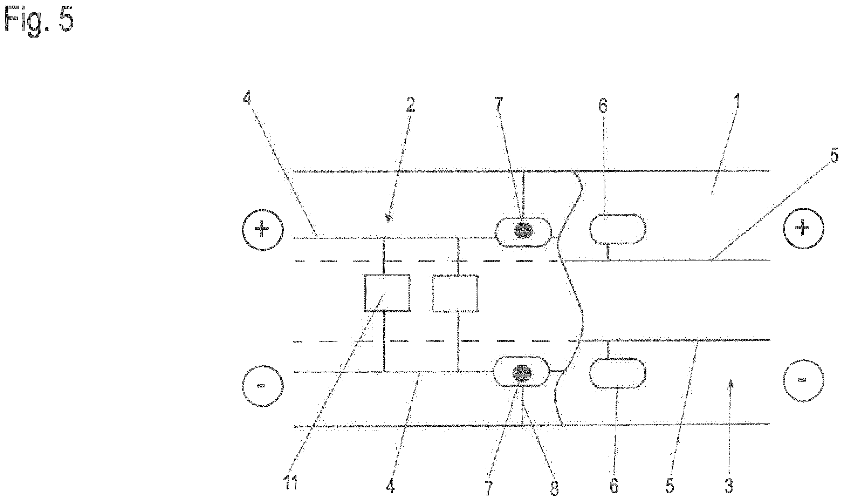

In den Figuren ist jeweils die Leuchtseite der Leiterplatine abgebildet mit LEDs 11 (Figur 5), die von einer lichtdurchlässigen Abdeckung 10 überdeckt sind.

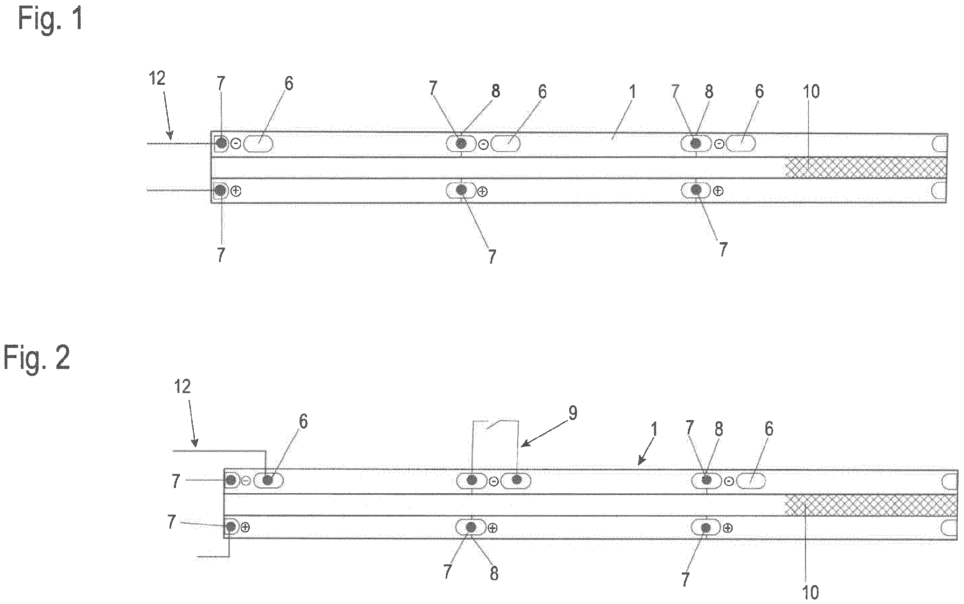

Die Trägerbahn 1 besteht aus einem biegsamen oder biegesteifen Material, an der zwei einen Funktionsstromleiter 2 bildende Funktionsleiterbahnen 4 angeordnet sind, die bei dem in der Figur 1 gezeigten Beispiel über Anschlusskontakte 7 an einen Netzanschluss 12 angeschlossen sind, mit einer Betriebsspannung von 12 Volt oder 24 Volt.

Weiter ist an der Trägerbahn 1, gemäß der Erfindung, zumindest eine einen Steuerstromleiter 3 bildende Steuerstromleiterbahn angeordnet, mit Kontaktstellen 6, die mit Funktionselementen in Verbindung stehen.

Die Figur 1 zeigt ein Beispiel, bei dem, im Gegensatz dazu, an dem Steuerstromleiter 3 keine Funktionselemente angeschlossen sind und bei dem der Netzanschluss 12 unmittelbar an den Funktionsstromleiter 2 angeschlossen ist. In diesem Fall leuchten die LEDs in Funktion, ohne von entsprechenden Funktionselementen, wie Schalt- oder Steuerelementen beeinflusst zu werden.

Bei dem in der Figur 2 gezeigten Ausführungsbeispiel hingegen ist an dem Steuerstromleiter 3, der in diesem Fall aus lediglich einer Steuerleiterbahn 5 besteht, eine Sensor-/Schalteinrichtung 9 angeschlossen, die mit dem Funktionsstromleiter 2 derart elektrisch in Verbindung steht, dass der Stromfluss zum Betrieb der LEDs 11 unterbrochen werden kann.

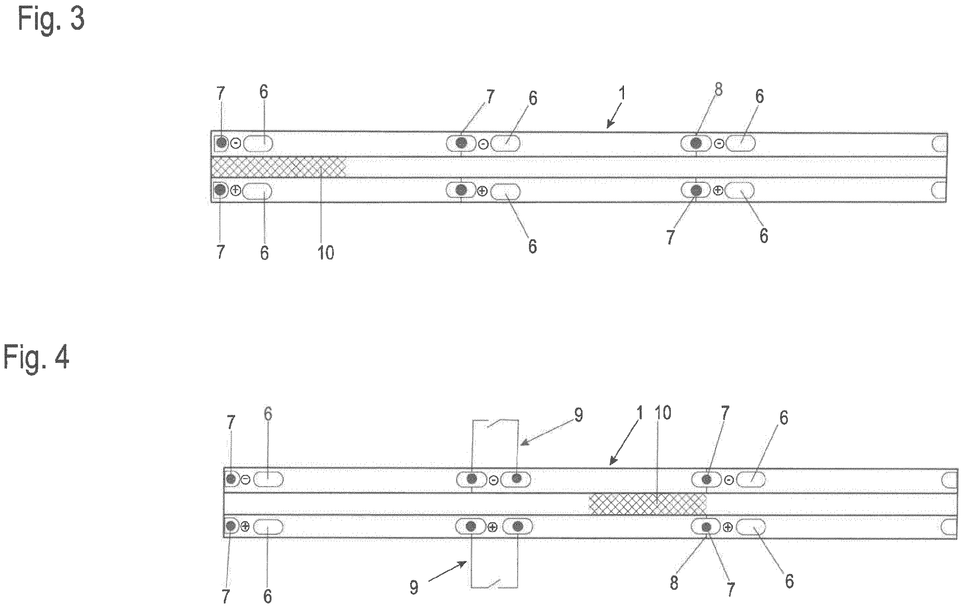

Die Figuren 3 und 4 zeigen eine Leiterplatine nach der Erfindung, bei der, entsprechend der Figur 5, die die LEDs 11 ohne Abdeckung 10 wiedergibt, der Steuerstromleiter 3 zwei Steuerleiterbahnen 5 aufweist, die mit Anschlusskontakten 7 an Netzstrom angeschlossen sind.

Während die Figur 3 eine Konfiguration der Leiterplatine zeigt, bei der keine Sensor- bzw. Schalteinrichtung 9 am Steuerstromleiter 3 angeschlossen ist, ist bei der Leiterplatine in der Figur 4 der Steuerstromleiter 3 mit Sensor/Schalteinrichtungen 9 bestückt und zwar jede der beiden Steuerleiterbahnen 5.

Durch Änderung der Stromflussrichtung können am Funktionsstromleiter 2 angeschlossene, warmweißes oder kaltweißes Licht emittierende LEDs betrieben werden.

Zur Abnahme des Stroms von dem Steuerstromleiter 3 zum Funktionsstromleiter 2 weisen die Steuerleiterbahnen 5 Kontaktstellen 6 auf, die über den Sensor 9 mit Anschlusskontakten 7 der Funktionsleiterbahnen 4 in Verbindung stehen.

Dabei sind die Anschlusskontakte 7 im Bereich von Trennstellen 8 angeordnet, von denen mehrere, in linearen Abständen zueinander vorgesehen sind und an denen die Leiterplatine durchtrennbar ist, um eine gewünschte Länge herzustellen. Prinzipiell können die Anschlusskontakte 7 auch an jeder beliebigen Stelle innerhalb der Abstände angeordnet sein

### Bezugszeichenliste

- 1: Trägerbahn
- 2: Funktionsstromleiter
- 3: Steuerstromleiter
- 4: Funktionsleiterbahn
- 5: Steuerleiterbahn
- 6: Kontaktstelle
- 7: Anschlusskontakt
- 8: Trennstelle
- 9: Sensor/Schalteinrichtung
- 10: Abdeckung
- 11: LED
- 12: Netzanschluss

## Patentansprüche

1. Leiterplatine mit an Niedervolt-Betriebsstrom angeschlossenen Leiterbahnen, die an einer Trägerbahn (1) angeschlossen sind und mit denen elektrische Funktionselemente verbunden sind, **dadurch gekennzeichnet, dass** mindestens zwei Ebenen vorgesehen sind, von denen auf einer Ebene zwei, einen Funktionsstromleiter (2) bildende Funktionsleiterbahnen (4) angeordnet sind, an denen Funktionselemente, insbesondere LEDs (11), angeschlossen sind, und auf der anderen Ebene zumindest eine, einen Steuerstromleiter (3) bildende Steuerleiterbahnen (5) angeordnet ist, mit Kontaktstellen (6), die über Funktionselemente mit Anschlusskontakten (7) des Funktionsstromleiters (2) verbindbar sind.

2. Leiterplatine nach Anspruch 1, **dadurch gekennzeichnet, dass** der Funktionsstromleiter (2) und/oder der Steuerstromleiter (3) an Netzstrom angeschlossen sind.

3. Leiterplatine nach Anspruch 1 oder 2, **dadurch gekennzeichnet, dass** die Ebene des Steuerstromleiters (3) neben oder über oder unter der Ebene des Funktionsstromleiters (2) angeordnet ist.

4. Leiterplatine nach einem der vorhergehenden Ansprüche, **dadurch gekennzeichnet, dass** an Funktionsleiterbahnen (4) des Funktionsstromleiters (2) LEDs angeschlossen sind.

5. Leiterplatine nach einem der vorhergehenden Ansprüche, **dadurch gekennzeichnet, dass** an dem Funktionsstromleiter (2) unterschiedliche LEDs angeordnet sind, die, je nach Stromflussrichtung, warmweißes oder kaltweißes Licht emittieren.

6. Leiterplatine nach einem der vorhergehenden Ansprüche, **dadurch gekennzeichnet, dass** jeder Steuerleiterbahn (5) des Steuerstromleiters (3) Funktionselemente in Form von Sensoren, Schalteinrichtungen oder dergleichen anschließbar sind.

7. Leiterplatine nach einem der vorhergehenden Ansprüche, **dadurch gekennzeichnet, dass** mit dem Steuerstromleiter (3) verbundene Funktionselemente als separate Komponenten außerhalb der Trägerbahn (1) angeordnet sind.

8. Leiterplatine nach einem der vorhergehenden Ansprüche, **dadurch gekennzeichnet, dass** die mit dem Steuerstromleiter (3) verbundenen Funktionselemente direkt auf der Trägerbahn (1) oder einer damit verbundenen Trägerschicht angeordnet sind.

9. Leiterplatine nach einem der vorhergehenden Ansprüche, **dadurch gekennzeichnet, dass** die Leiterplatine linear in Abständen Trennstellen (8) aufweist, denen die Anschlusskontakte (7) zugeordnet sind, wobei die Trennstellen (8) durch Markierungen oder Prägungen kenntlich sind, an denen die Leiterplatine trennbar ist.

10. Leiterplatine nach einem der vorhergehenden Ansprüche, **dadurch gekennzeichnet, dass** die Kontaktstellen (6) und/oder die Anschlusskontakte (7) außerhalb der Trennstellen positioniert sind.
